(19) Europäisches Patentamt
European Patent Office
Office européen des brevets

(11) **EP 1 795 910 B1**

(12) **EUROPÄISCHE PATENTSCHRIFT**

(45) Veröffentlichungstag und Bekanntmachung des Hinweises auf die Patenterteilung:
**14.01.2009   Patentblatt 2009/03**

(51) Int Cl.:
***G01R 33/30*** *(2006.01)*      ***B01L 3/14*** *(2006.01)*

(21) Anmeldenummer: **06024684.0**

(22) Anmeldetag: **29.11.2006**

(54) **Reduktion der Wirbelstromverluste in elektrisch leitenden Probensubstanzen mit Hilfe von speziellen NMR-Probengläschen**

Reduction of eddy current losses in electrically conductive samples by means of special NMR sample tubes

Réduction des courants de Foucault dans des substances éléctroconductrices au moyen des tubes spéciaux à échantillon pour la RMN

(84) Benannte Vertragsstaaten:
**CH DE FR GB LI**

(30) Priorität: **06.12.2005   DE 102005058195**

(43) Veröffentlichungstag der Anmeldung:
**13.06.2007   Patentblatt 2007/24**

(73) Patentinhaber: **Bruker BioSpin AG**
**8117 Fällanden (CH)**

(72) Erfinder:
• **Stauffenegger, Philippe**
**8600 Dübendorf (CH)**

• **Schett, Oskar**
**8610 Uster (CH)**

(74) Vertreter: **Kohler Schmid Möbus**
**Patentanwälte**
**Ruppmannstrasse 27**
**70565 Stuttgart (DE)**

(56) Entgegenhaltungen:
**US-B2- 6 917 201**

**Beschreibung**

Die Erfindung betrifft ein Probengläschen für einen NMR (=Kernspinresonanz) - Probenkopf, das längs einer z-Achse verläuft und dessen Innenraum einen axial in Richtung der z-Achse verlaufenden Hohlraum bildet, der am axial oberen Ende nach außen geöffnet und am axial unteren Ende geschlossen ist zur Aufnahme einer flüssigen NMR-Probensubstanz, wobei zumindest über einen Teilabschnitt des Hohlraums, der kleiner ist als die gesamte axiale Länge L des Probengläschens, die zur z-Achse senkrecht verlaufende und parallel zur xy-Koordinatenebene liegende Querschnittsfläche dieses Hohlraums eine in Richtung der x-Achse lang gezogene Form besitzt mit den maximalen Abmessungen a in y-Richtung und b in x-Richtung, wobei gilt: a < b.

Ein solches Probengläschen ist z.B. bekannt aus der US 6,917,201 B2.

Das Detektionssystem eines NMR-Spektrometers besteht aus dem NMR-Resonator und dem innerhalb des NMR-Resonators befindlichen Probengläschen, welches die zu messende Probensubstanz enthält. Wenn nun die Probensubstanz aus einer elektrisch leitenden Lösung besteht, z.B. einer Salzlösung, dann beeinflusst diese die optimale Funktionsweise des NMR-Resonators und führt unter anderem zu einer Verschlechterung des Signal-zu-Rausch-Verhältnisses (= SINO) des NMR-Empfangssystems. Der SINO ist jedoch eines der wichtigsten Parameter eines NMR-Spektrometers, weshalb das Interesse nach Lösungen für dieses Problem groß ist.

Der NMR-Resonator hat einerseits die Aufgabe, die hochfrequenten Feldimpulse (= HF-Impulse) zur erzeugen, mit denen die magnetischen Spins innerhalb der Probensubstanz angeregt werden, andererseits aber auch die Aufgabe, das FID-Signal, das von den angeregten Spins abgegeben wird, möglichst rauscharm zu empfangen.

Die HF-Impulse erzeugen in der elektrisch leitenden Probensubstanz Wirbelströme, die zu Wirbelstromverlusten führen und die Güte (= Q-Wert) des auf diese Weise belasteten NMR-Resonators verschlechtern. Bei kryogen gekühlten Resonatoren, die im unbelasteten Zustand normalerweise sehr hohe Q-Werte von über 3000 besitzen, macht sich dieser Effekt besonders stark bemerkbar. Man kann zeigen, dass bei einer Salzkonzentration ab ca. 200 mMolar der Q-Wert dieser NMR-Resonatoren im belasteten Zustand praktisch nur noch von den Wirbelstromverlusten in der Probensubstanz bestimmt wird. Der schlechtere Q-Wert hat nun zur Folge, dass mehr HF-Energie in das Detektionssystem geleitet werden muss, da auch die Verluste in der Probensubstanz gedeckt werden müssen.

Während des Sendevorganges erzeugt das vom NMR-Resonator in die Probensubstanz pulsförmig eingestrahlte Feld (= $B_1$-Feld) eine räumliche Drehung der magnetischen Spins um einen gewünschten Winkel (= Flipwinkel). Der Flipwinkel ist proportional zum Produkt (Feldamplitude des $B_1$-Feldimpulses) mal (Zeitdauer des $B_1$-Feldimpulses). Infolge des verschlechterten Q-Wertes des HF-Resonators, wird bei einer gegebenen Pulsleistung des Senders weniger Feldamplitude und damit auch ein kleinerer Flipwinkel erzeugt. Um wieder auf den gewünschten Flipwinkel zu kommen, muss entweder die Pulsleistung des Senders erhöht oder die Zeitdauer des HF-Impulses vergrößert werden.

Während des Empfangsvorganges verhalten sich die angeregten magnetischen Spins wie kleine HF-Sender, die ein hochfrequentes Signal, nämlich das FID-Signal, abstrahlen. Dieses verursacht ebenfalls Verlustbehaftete Wirbelströme in der leitenden Probensubstanz, so dass das FID-Signal mit zusätzlichem Rauschen überlagert und das SINO verschlechtert wird.

Zu beachten ist ferner, dass bei Verwendung von kryogen gekühlten Probenköpfen (= Kryoprobenköpfen), Temperaturgradienten innerhalb der Probensubstanz auftreten können, die normalerweise störend auf die Qualität des NMR-Spektrums wirken. Kryoprobenköpfe besitzen ein doppelwandiges Dewar mit einer Vakuumisolation dazwischen, sowie einer Innenbohrung auf Raumtemperatur (ca. 295 K), in welche das Probengläschen eingeführt wird. Im thermisch isolierten Raum, das auf eine Temperatur von ca. 15 K gekühlt wird, befindet sich der NMR-Resonator. Zwischen Probengläschen und NMR-Resonator herrscht also eine Temperaturdifferenz von ca. 280 K, und das hat zur Folge, dass das Probengläschen viel Wärme in den kryogen gekühlten Raum des Dewars hinein strahlt. Das Probengläschen muss deshalb durch einen Luftstrom, der im engen Zwischenraum zwischen Probengläschen und Dewarwand fließt, ständig erwärmt werden. Der Zwischenraum muss sehr eng sein, damit das Probengläschen ein möglichst großes Volumen und einen möglichst großen Füllfaktor in Bezug zum NMR-Resonator erreicht, denn beides führt zu einem höheren SINO. Der Zwischenraum muss aber auch sehr konstant sein, damit die gesamte Oberfläche des Probengläschens gleichmäßig erwärmt wird und störende Temperaturgradienten in der Probensubstanz vermieden werden. Erreicht wird dieses Ziel durch eine exakte axiale und radiale Positionierung des Probengläschens in Bezug zur Dewarwandung, was z.B. mit Hilfe von Zentrierungsfedern im unteren Bereich des Probengläschens erreicht werden kann [3].

**Stand der Technik**

Berechnungen [1,2] haben gezeigt, dass wenn die Verluste im NMR-Resonator gegenüber den Wirbelstromverlusten der Probensubstanz vernachlässigt werden können, dass dann die Querschnittsfläche der Probensubstanz bis zu einem bestimmten Maß verkleinert werden kann ohne dass dadurch das SINO verschlechtert wird. Der Grund dafür liegt in der Tatsache, dass sowohl das Rauschsignal der Wirbelströme wie auch das FID-Signal der Spins aus der selben Quelle stammen, nämlich der Probensubstanz, und deshalb im gleichen Maß kleiner werden und den Wert für das SINO unverändert lassen. Auch der Übertragungsweg der beiden Signale bis zum NMR-Resonator ist derselbe, so dass ihre Amplitude und Phase im gleichen Maß verändert werden und das SINO ebenfalls erhalten bleibt. Was sich ändert, ist einzig die Amplitude der beiden Signale, die vom NMR-Resonator empfangen werden, denn diese werden beide kleiner.

Die Erhaltung des SINO gilt aber nur bis zu einer bestimmten Verkleinerung der Querschnittsfläche, ab der dann die Verluste im NMR-Resonator immer dominanter gegenüber den Wirbelstromverlusten werden. Der Hauptanteil des Rauschsignals entsteht dann im NMR-Resonator selbst, ist unabhängig von der Probensubstanz und hat keinen Übertragungsweg zu durchlaufen. Das FID-Signal hingegen ist einerseits schwächer, weil die Querschnittsfläche und damit auch das Volumen der Probensubstanz abgenommen haben, und zweitens weil es den Übertragungsweg bis zum NMR-Resonator durchlaufen muss. Beides führt zu einem schwächeren FID-Signal im NMR-Resonator und damit zu einem schlechteren SINO.

Es besteht eine Möglichkeit, das SINO zu verbessern, indem für die Querschnittsfläche der Probensubstanz nicht mehr eine runde Form gewählt wird, sondern eine, die möglichst kleine Wirbelstromverluste erzeugt. Berechnungen und Experimente haben gezeigt [1,2], dass die Querschnittsfläche lang gezogen sein muss, z.B. rechteckig oder elliptisch, und dass die längere Abmessung der Querschnittsfläche parallel zur Richtung des $B_1$-Feldes ausgerichtet sein muss.

In diesem Fall müssen demnach zwei Größen gleichzeitig korrekt gewählt resp. eingestellt werden, nämlich erstens die Form der Querschnittsfläche der Probensubstanz, und zweitens die Ausrichtung der längeren Achse der Querschnittsfläche, die parallel zum H1-Feld liegen muss. Ein um seine Achse rotierendes Probengläschen, wie dies in der hochauflösenden NMR-Spektroskopie üblich ist, ist natürlich hier nicht mehr möglich. Da jedoch mit salzhaltigen Probensubstanzen keine Höchstauflösung zu erwarten ist, führt dieser Umstand mit den heute zur Verfügung stehenden Shimsystemen zu keinem merklichen Nachteil.

Sowohl die rechteckige wie auch die elliptische Querschnittsform sind Formen, die eine Quer- und eine Längsabmessung a resp. b besitzen, wobei a < b. Es stellt sich nun die Frage, ob ein optimales Verhältnis $(a/b)_{opt}$ vorhanden ist, welches das größte SINO liefert, und wenn ja, von welchen weiteren Größen dieses noch abhängen könnte.

Vorerst soll von einer quadratischen Querschnittsform mit der Querschnittsfläche $q = a \cdot b = s^2$ ausgegangen werden, wobei s die Seitenlänge des Quadrats ist. Hier gelten ähnliche Zusammenhänge wie bei der weiter oben beschriebenen runden Querschnittsform, d.h. das SINO bleibt bei kleiner werdendem q konstant bis zu einem minimalen Wert von $q = q_{min}$, der dann auftritt, wenn die Verluste im NMR-Resonator langsam in Erscheinung treten und das SINO anfängt kleiner zu werden. Dieser Spielraum für q kann dazu verwendet werden, mit einer optimalen Wahl des Verhältnisses (a / b) die Wirbelstromverluste zu verkleinern.

Der Wert für a muss so klein wie möglich gewählt werden, weil dadurch die Wirbelstromverluste ebenfalls so klein wie möglich werden. Der Grund dafür liegt in der Umrissfläche der Probensubstanz, die dem B1-Feld zugewandt ist und von ihm bestrahlt wird. Bei sinkendem Wert a wird diese Umrissfläche immer kleiner, so dass kleinere Wirbelströme induziert werden und darum auch kleinere Rauschkomponenten entstehen. Das wirkt sich positiv auf das SINO aus.

Mit kleiner werdendem a wird aber auch die Querschnittsfläche der Probensubstanz bei einem gegeben Wert für b immer kleiner, bis die minimale Querschnittsfläche $q_{min}$ erreicht wird. Ab dieser Querschnittsfläche darf a nicht mehr weiter verkleinert werden. Um a dennoch weiter verkleinern zu können, muss b vergrößert werden. Dies ist aber nur so lange möglich, bis b seinen maximalen Wert $b = b_{max}$ erreicht, was dann der Fall ist, wenn b durch den Durchmesser der RT-Bohrung des Dewars begrenzt wird. Damit ergeben sich für die optimalen Abmessungen der Querschnittsfläche die Werte:

$$b = b_{max}$$

$$a = q_{min} / b_{max}$$

$$(a / b)_{opt} = q_{min} / (b_{max})^2$$

Da die Wirbelstromverluste zudem noch von der Konzentration der Salzlösung abhängen, gilt für jeden Konzentrationswert der Salzlösung ein anderer Wert für $q_{min}$, d.h. wenn die Salzkonzentration größer ist, resultiert ein kleineres $q_{min}$, und umgekehrt, wenn sie kleiner ist, ein größeres $q_{min}$. Das bedeutet, dass mit zunehmender Salzkonzentration das optimale a und somit auch das optimale Seitenverhältnis resp. Achsenverhältnis a / bmax immer kleiner wird, so dass die Querschnittsfläche eine immer stärker in die Länge gezogene Form annimmt.

**Das erfindungsgemäße Probengläschen**

Daraus ergibt sich nun allerdings das Problem, dass derart geformte Probengläschen nicht mehr ohne weiteres in die üblichen, standardmäßigen Aufnahmeöffnungen für die Proben von NMR-Spektrometern passen. Es ist daher die Aufgabe der Erfindung, ein Probengläschen für einen NMR-Probenkopf zur Verfügung zu stellen, welches einerseits vollständig die oben diskutierten Vorteile einer geometrischen Optimierung der Querschnittsflächen im Hinblick auf eine erhebliche Verbesserung des SINO aufweist, wobei jedoch mit einfachen Mitteln und technisch leicht realisierbar eine problemlose und passgenaue Einführung des Probengläschens in standardisierte Aufnahmeöffnungen und Zentriervorrichtungen herkömmlicher Probenköpfe von NMR-Spektrometern ermöglicht werden soll.

Diese Aufgabe wird auf überraschend einfache, aber dennoch wirkungsvolle Weise erfindungsgemäß durch ein NMR-Probengläschen der eingangs vorgestellten Art gelöst, das dadurch gekennzeichnet ist, dass die zur z-Achse senkrecht verlaufende und parallel zur xy-Koordinatenebene liegende Querschnittsfläche des Probengläschens eine kreisrunde äußere Form besitzt.

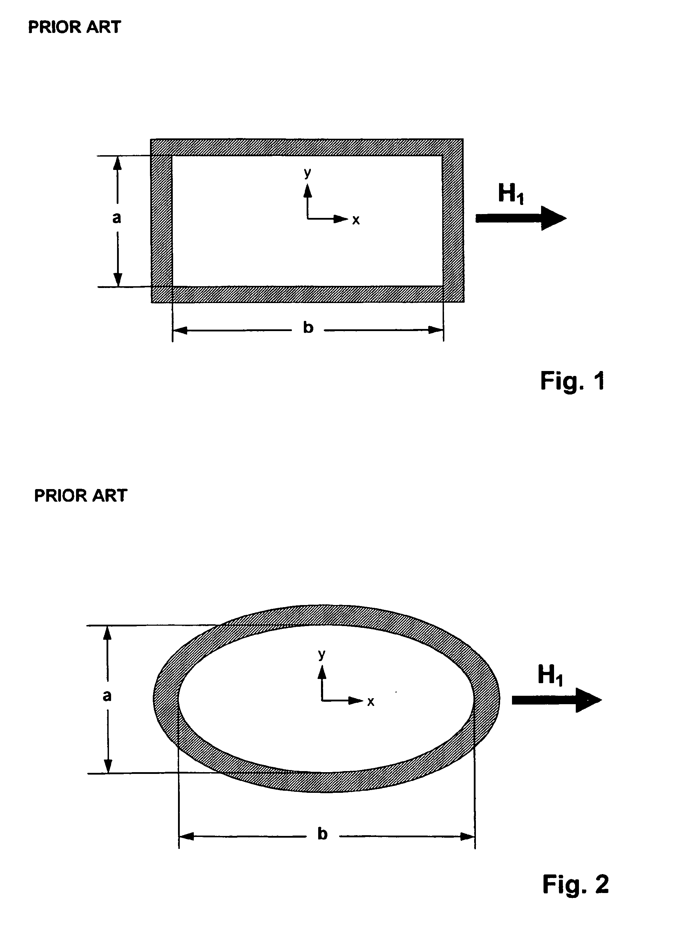

Im Gegensatz zu den in [2] beschriebenen Probengläschen (Fign. 1 und 2) nach dem Stand der Technik, die über den gesamten Umfang praktisch eine konstante Wandstärke besitzen, ist das bei den erfindungsgemäßen Probengläschen nicht der Fall. Letztere besitzen nämlich eine zylinderförmige Außenfläche, d.h. die äußere Querschnittsform ist wie bei den konventionellen Probengläschen kreisrund, die innere Querschnittsform hingegen annähernd rechteckig. Die Wandstärke dieser erfindungsgemäßen Probengläschen ändert demnach stark über den Umfang gesehen.

Solche Probengläschen haben den großen Vorteil, dass sie in einen konventionellen Kryoprobenkopf gesteckt und dort mit der bereits vorhandenen Präzisions-Zentrierungsvorrichtung axial und radial positioniert werden können. Auch der Probenhalter, der das Probengläschen am oberen Ende hält, ist ein konventioneller Probenhalter. Mit anderen Worten, ob ein Probengläschen mit einer kreisrunden oder einer rechteckigen Querschnittsform der Probensubstanz verwendet wird, am bestehenden Probenkopf muss nichts geändert werden!

Für den Benutzer bedeutet dies einerseits eine vereinfachte Handhabung beim experimentieren, denn er braucht nicht jedes Mal, wenn er von rund auf rechteckig wechselt, den Probenkopf zu ändern, und zudem braucht er auch keinen neuen Probenkopf anzuschaffen, da der bestehende für die runden Probengläschen auch für die rechteckigen benutzt werden kann, ohne dadurch Nachteile in Kauf nehmen zu müssen.

Bei einfachen Ausführungsformen des erfindungsgemäßen Probengläschens besitzt der Hohlraum über die gesamte axiale Länge L des Probengläschens eine in Richtung der x-Achse lang gezogene Form mit den maximalen Abmessungen a in y-Richtung und b in x-Richtung, wobei a < b.

Alternativ kann jedoch auch der Hohlraum lediglich über einen Teilabschnitt $L_Z$, der kleiner ist als die gesamte Länge L des Probengläschens, eine in Richtung der x-Achse lang gezogene Form besitzen mit den maximalen Abmessungen a in y-Richtung und b in x-Richtung, wobei a < b.

Vorteilhafte Weiterbildungen dieser Ausführungsformen zeichnen sich dadurch aus, dass der Hohlraum durch ein Probengläschen mit kreisrunder Querschnittsfläche und zwei in dem Probengläschen mit kreisrunder Querschnittsfläche angeordneten Präzisionsschalen der Länge $L_Z$ gebildet wird, wobei die Präzisionsschalen mit der Innenwand des Hohlraums verbunden und möglichst genau diametral zueinander positioniert sind, wobei jede der beiden Präzisionsschalen eine Form besitzt, die entlang der Länge $L_Z$ durch zwei sich über den Umfang schließende Flächen definiert ist, nämlich eine erste, die zylinderförmig ist und möglichst genau die gleiche Krümmung wie die des Hohlraums des Probengläschens besitzt, und eine zweite, die vollständig eben ist und parallel zur Achse der ersten zylinderförmigen Fläche verläuft, wobei die beiden ebenen Flächen der beiden Präzisionsschalen parallel zueinander liegen und einen annähernd rechteckförmigen Hohlraum definieren, der im Betrieb ganz oder teilweise durch eine Probensubstanz gefüllt ist.

Dies lässt sich besonders einfach dadurch erreichen, dass die Verbindung zwischen den beiden Präzisionsschalen und der kreisrunden Querschnittsfläche des Hohlraums durch einen Verschmelzungsvorgang erzielt wird.

Vorteilhaft ist es auch, wenn das untere Ende der beiden Präzisionsschalen mit einer runden Scheibe fest verbunden ist, so dass keine Probensubstanz in den Raum unterhalb der Scheibe gelangen kann.

Bevorzugt sind Ausführungsformen des erfindungsgemäßen Probengläschens, bei denen das Ausgangsmaterial zur Herstellung des Probengläschens Glas, oder eine Glasverbindung wie z.B. Pyrex, oder Quarzglas ist.

Bei besonders vorteilhaften Ausführungsformen wird das obere und untere Ende der im Betrieb im Probengläschen befindlichen Probensubstanz durch je einen Suszeptibilitätseinsatz abgeschlossen, dessen Material einen magnetischen Suszeptibilitätswert besitzt, der annähernd gleich dem der Probensubstanz ist.

Dies lässt sich noch dadurch verbessern, dass die Positionen der Suszeptibilitätseinsätze in Bezug zum Probengläschen so gewählt sind, dass während des Messvorgangs die Probensubstanz im maximalen Feldbereich des B1-Feldes zentriert ist.

Ein Suszeptibilitätseinsatz für ein Probengläschen der oben beschriebenen erfindungsgemäßen Art wird bevorzugt aus einem Material bestehen, das für Probensubstanzen mit wässrigen Lösungsmitteln geeignet ist, beispielsweise "PPS" (p-Phenylen Sulfid) oder "ULTEM" (p-Etherimid).

Der Suszeptibilitätseinsatz kann eine Länge von ein bis zwei Mal dem Außendurchmesser des Probengläschens aufweisen und mit einem Spiel von vorzugsweise 10 μm in den Querschnitt des Hohlraums passen.

Der Suszeptibilitätseinsatz für ein Probengläschen der erfindungsgemäßen Art kann auch an einem Ende ein axial verlaufendes Gewinde besitzen, in welches eine Montagestange ein- und ausgeschraubt werden kann, wobei diese Montagestange z.B. aus "TEFLON" oder "POM" hergestellt werden kann.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung näher dargestellt und erläutert. Es zeigen:

Fig. 1    einen schematischen Querschnitt durch ein rechteckiges Probengläschen nach dem Stand der Technik;

Fig.2    einen Querschnitt durch ein elliptisches Probengläschen nach dem Stand der Technik;

Fig.3    einen Querschnitt durch ein erfindungsgemäßes Probengläschen mit nahezu rechteckigem Innenquerschnitt, das durch einen Ziehvorgang hergestellt wurde;

Fig.4    einen Querschnitt durch ein erfindungsgemäßes Probengläschen mit nahezu rechteckigem Innenquerschnitt, das mit Hilfe zweier Präzisionsschalen und hergestellt wurde;

Fig.5    eine schematische räumliche Ansicht eines Probengläschens nach Fig.3;

Fig.6    eine räumliche Ansicht eines Probengläschens nach Fig.4, wobei am unteren Rand der beiden Präzisionsschalen eine Abschlussscheibe angebracht ist; und

Fig.7    einen Querschnitt durch ein erfindungsgemäßes Probengläschen, bei dem die Höhe der Probensubstanz durch zwei Suszeptibilitäts-Einsätze begrenzt wird.

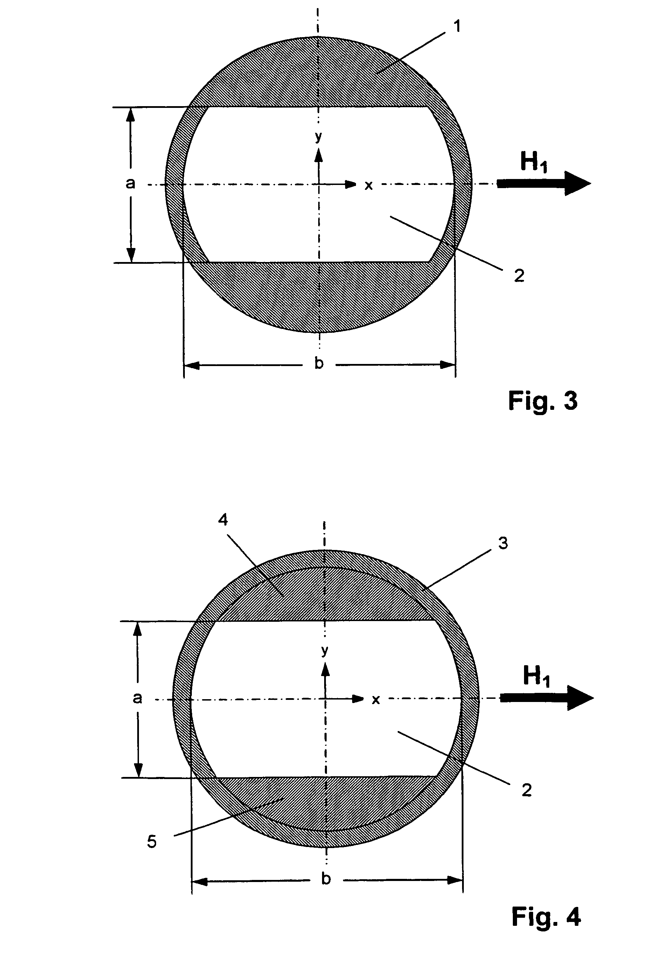

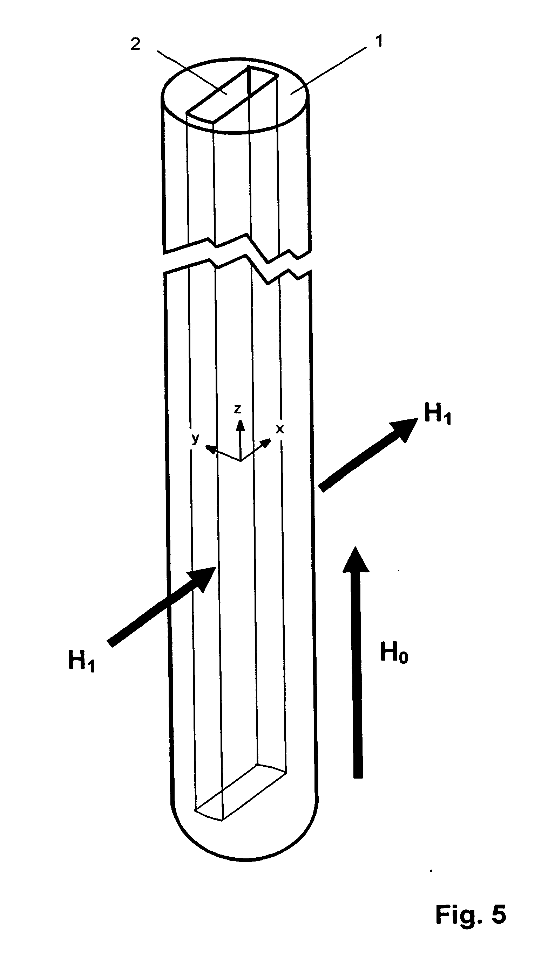

Die Herstellung erfindungsgemäßer Probengläschen aus Glas ist technisch relativ einfach machbar, wobei zwei Herstellungsverfahren näher erläutert werden sollen. Das erste Verfahren benutzt ein rechteckförmiges Ziehwerkzeug, mit dem der rechteckförmige Innenraum des Probengläschens mit Hilfe eines Ziehvorganges an einem zylinderförmigen Glaskörper erzeugt wird. Der zylinderförmige Glaskörper besitzt vorzugsweise eine axial verlaufende runde Bohrung, deren Durchmesser leicht kleiner als die kleinere Abmessung b des gewünschten Rechtecks ist. Die runde Bohrung dient dann als Führung für das rechteckförmige Zieh-Werkzeug. In Fig.3 und Fig.5 sind solche Probengläschen dargestellt. Im Innern des Probengläschens 1 befindet sich der annähernd rechteckförmige Innenraum 2.

Das zweite Herstellungsverfahren hat den Vorteil, dass es kein Ziehwerkzeug benötigt und deshalb besonders geeignet ist, kleine Serien oder Einzelexemplare herzustellen. Man benötigt dazu erstens ein konventionelles rundes Probengläschen 3 vorzugsweise aus Glas und mit einem Hohlraum, der eine kreisrunde Querschnittsfläche besitzt, sowie zweitens zwei Präzisionsschalen 4 und 5 der Länge $L_Z$, die ebenfalls vorzugsweise aus Glas hergestellt, mit der Innenwand des Hohlraums verbunden und möglichst genau diametral zueinander positioniert sind, wobei jede der beiden Präzisionsschalen eine Form besitzt, die entlang der Länge $L_Z$ durch zwei sich über den Umfang schließende Flächen definiert ist, nämlich eine erste, die zylinderförmig ist und möglichst genau die gleiche Krümmung wie die des Hohlraums des Probengläschens besitzt, und eine zweite, die vollständig eben ist und parallel zur Achse der ersten zylinderförmigen Fläche verläuft, wobei die beiden ebenen Flächen der beiden Präzisionsschalen parallel zueinander liegen und einen annähernd rechteckförmigen Hohlraum definieren, der ganz oder teilweise durch die Probensubstanz gefüllt ist.

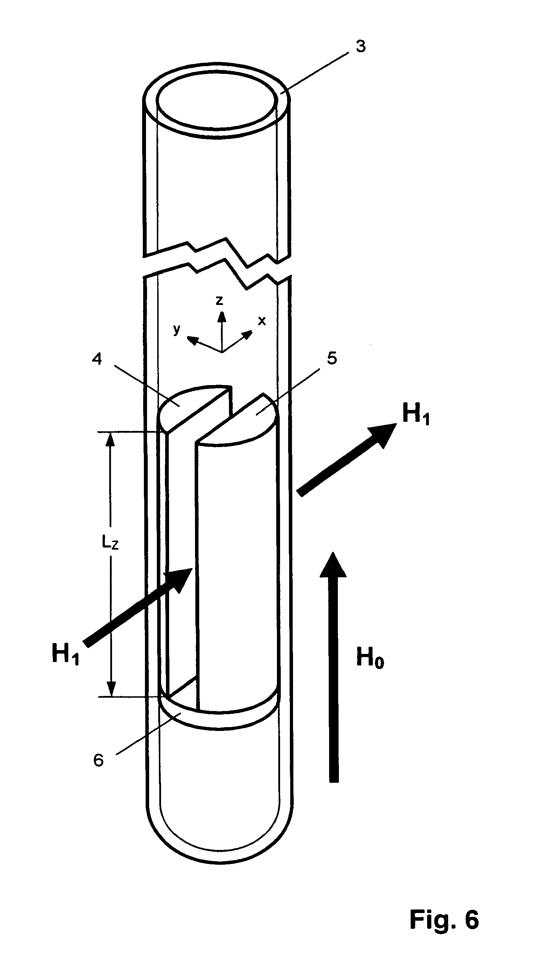

Die beiden Präzisionsschalen, die z.B. bei einem Probengläschen mit dem Außendurchmesser von ca. 5 mm eine Länge $L_Z$ von ca. 60 mm besitzen können, werden diametral zueinander an die innere Wand der kreisrunden Bohrung gepresst und die Kontaktflächen durch eine anschließende Erwärmung auf eine genau zu bestimmende Temperatur miteinander verschmolzen (Fig.4 und Fig.6). Die Temperatur muss einerseits so tief gewählt werden, dass das Probengläschen und die beiden Präzisionsschalen nicht deformiert werden, anderseits aber genügend hoch, so dass der Verschmelzungsvorgang an den Kontaktflächen stattfinden kann. Sehr wichtig ist, dass der Verschmelzungsvorgang über die gesamte Kontaktfläche stattfindet, um zu vermeiden, dass Probensubstanz in den kritischen Bereich zwischen den Kontaktflächen eindringen kann. Dieser Bereich erzeugt nämlich erhöhte Wirbelstromverluste und würde den Gewinn an SINO stark reduzieren.

Da für die Präzisionsschalen inertes Material, z.B. Glas, verwendet wird, können beliebige Lösungsmittel verwendet werden. Das ganze Probengläschen ist auch mehrfach verwendbar, da es gereinigt werden kann.

Durch Anbringen einer Scheibe 6 unterhalb der beiden Präzisionsschalen (Fig. 6), kann die Menge der Probensubstanz begrenzt werden, was insbesondere dann vorteilhaft ist, wenn es sich um eine sehr teure Substanz handelt. Zudem verhindert man mit dieser Scheibe, dass Probensubstanz in den unteren Bereich, insbesondere in die untere Rundung des Probengläschens gelangen kann, was die Qualität des NMR-Spektrums ("water hump" und "splitting") verbessern und zu einer höheren Empfindlichkeit führen kann.

Die Füllhöhe der Probensubstanz muss normalerweise 2.5 bis 4 Mal so groß gewählt werden wie die aktive Höhe der Probensubstanz. Die aktive Höhe ist definiert durch den Bereich in z-Richtung der Probensubstanz, der vom HF-Resonator bestrahlt wird und zur Anregung der magnetischen Spins führt. Außerhalb dieses Bereiches findet praktisch keine Anregung mehr statt, und man könnte versucht sein, die Füllhöhe der Probensubstanz ungefähr gleich dieser aktiven Höhe zu wählen, was insbesondere bei sehr teuren Probensubstanzen wünschenswert wäre. Das würde aber zu spürbaren Nachteilen führen, da an den beiden Enden der Probensubstanz Suszeptibilitätssprünge vorhanden sind, die durch die unterschiedlichen magnetischen Suszeptibilitätswerte der Probensubstanz und des angrenzenden Mediums (z.B. Luft, Glas) entstehen, und das hätte Inhomogenitäten des $H_0$-Feldes und deshalb eine Verschlechterung des NMR-Spektrums zur Folge.

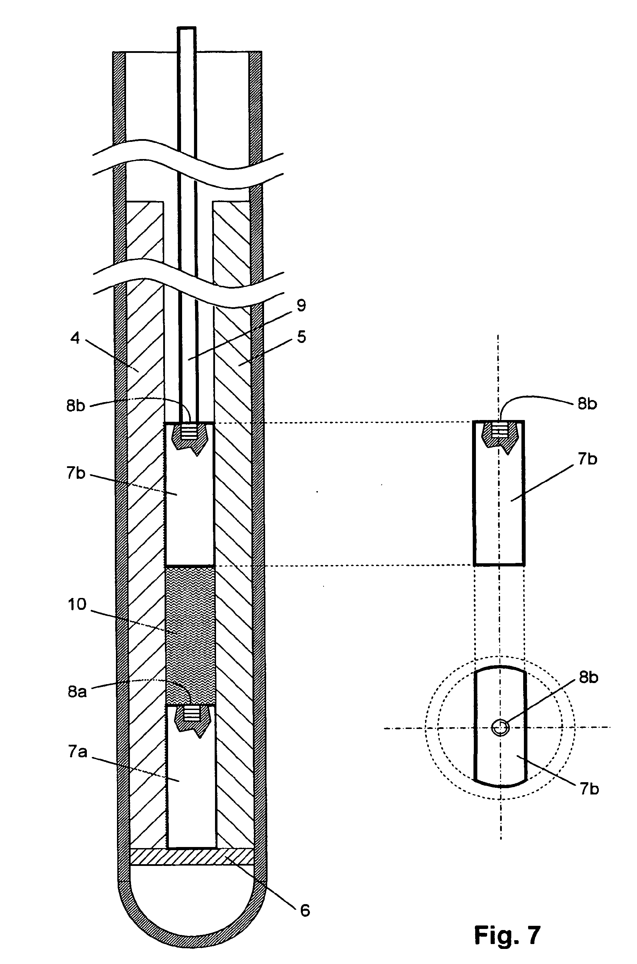

Eine Lösung dieses Problems besteht darin, so genannte Suszeptibilitätseinsätze (= SZ-Einsätze) 7a und 7b an den beiden Enden der Probensubstanz einzuführen (Fig. 7), wobei der magnetische Suszeptibilitätswert dieser SZ-Einsätze annähernd gleich dem der Probensubstanz sein sollte. Dadurch verschieben sich die Suszeptibilitätssprünge an jene Enden der SZ-Einsätze, die am weitesten entfernt von der Probensubstanz sind, so dass die dort entstehenden Ho-Inhomogenitäten zu weit entfernt sind, um das NMR-Spektrum beeinflussen zu können.

Da die Probensubstanzen im Allgemeinen unterschiedliche Suszeptibilitäten besitzen, müssen auch genügend SZ-Einsätze mit unterschiedlichen Suszeptibilitäten zur Verfügung stehen. Die bei Probengläschen mit rechteckigem Hohlraum verwendeten Probensubstanzen enthalten vorwiegend wasserhaltige Lösungsmittel, so dass die dazu passenden SZ-Einsätze z.B. aus "PPS" (= p-Phenylen-Sulfid) oder "ULTEM" (= p-Etherimid) hergestellt werden können.

Die SZ-Einsätze 7a, 7b besitzen jeweils ein Gewindeloch 8a, 8b, in das eine Montagestange 9, die an einem Ende mit einem Gewinde versehen ist, hineingeschraubt werden kann. Mit dieser Montagestange, die z.B. aus "TEFLON" oder "POM" hergestellt werden kann, lassen sich die beiden SZ-Einsätze in den rechteckigen Hohlraum des Probengläschens einführen und positionieren. Zuerst wird der untere SZ-Einsatz 7a montiert, anschließend die Montagestange heraus geschraubt und die Probensubstanz eingefüllt. Zum Schluss wird der obere SZ-Einsatz 7b montiert und die Montagestange wieder entfernt.

Damit beim Einführen der SZ-Einsätze die Luft, die im Hohlraum des Probengläschens vorhanden ist, entweichen kann, genügt ein Spiel von ca. 10 $\mu$m zwischen SZ-Einsatz und der Innenwand des Hohlraums.

Die Länge des SZ-Einsatzes sollte vorzugsweise gleich ein bis zwei Mal den Außendurchmesser des Probengläschens sein.

Die Positionen der beiden SZ-Einsätze in Bezug zum Probengläschen werden so gewählt, dass während dem Messvorgang die Probensubstanz 10 im maximalen Feldbereich des B1-Feldes zentriert ist.

Ein weiterer Vorteil erkennt man beim näheren Betrachten der rechteckigen Querschnittsformen der erfindungsgemäßen Probengläschen in Fig.3 und Fig.4. Diese sind nicht exakt rechteckförmig, sondern besitzen Rundungen an den beiden Enden der längeren Abmessung b. Insbesondere bei schwach konzentrierten Salzlösungen, wo sich die optimale Querschnittsform der quadratischen Form nähert, bringen diese Rundungen deutliche Vorteile, indem der mittlere Wert für $b_{max}$ deutlich größer ist als bei einer einfachen rechteckigen Form. Ein größeres $b_{max}$ führt aber zu einem kleineren optimalen Wert für a und damit zu kleineren Wirbelstromverlusten.

## Bezugszeichenliste

| | |
|---|---|
| 1 | Probengläschen, das durch ein Ziehverfahren hergestellt wurde |
| 2 | rechteckiger Hohlraum des Probengläschens |
| 3 | Probengläschen, in das die beiden Präzisionsschalen 4 und 5 eingesetzt werden. |
| 4, 5 | Präzisionsschalen, die ins Probengläschen 3 eingesetzt werden. |
| 6 | Scheibe, mit der das untere Ende der Präzisionsschalen abgeschossen wird. |
| 7a, 7b | Suszeptibilitätseinsätze (= SZ-Einsätze) |
| 8a, 8b | Gewindebohrungen in den Suszeptibilitätseinsätzen, die zur Befestigung der Montagestange 9 dienen. |
| 9 | Montagestange, die zur Einführung und Entfernung der Suszeptibilitätseinsätze 7a und 7b dient |
| 10 | Probensubstanz mit minimiertem Volumen |

## Referenzliste

[1] Th. De Swiet, ‚Optimal electric fields for different sample shapes in high resolution NMR spectroscopy', JMR 174 (2005) 331-334

[2] Patent US 6,917,201 B2
"Squashed liquid NMR sample tubes and RF coils"

[3] Patent DE 100 06 324 C1
"Gekühlter NMR-Probenkopf mit Vorrichtung zur Zentrierung der Messproben"

## Patentansprüche

1.  Probengläschen für einen NMR-Probenkopf, das längs einer z-Achse verläuft und dessen Innenraum einen axial in Richtung der z-Achse verlaufenden Hohlraum bildet, der am axial oberen Ende nach außen geöffnet und am axial unteren Ende geschlossen ist zur Aufnahme einer flüssigen NMR-Probensubstanz, wobei zumindest über einen Teilabschnitt des Hohlraums, der kleiner ist als die gesamte axiale Länge L des Probengläschens, die zur z-Achse senkrecht verlaufende und parallel zur xy-Koordinatenebene liegende Querschnittsfläche dieses Hohlraums eine in Richtung der x-Achse lang gezogene Form besitzt mit den maximalen Abmessungen a in y-Richtung und b in x-Richtung, wobei a<b, **dadurch gekennzeichnet, dass** die zur z-Achse senkrecht verlaufende und parallel zur xy-Koordinatenebene liegende Querschnittsfläche des Probengläschens eine kreisrunde äußere Form besitzt.

2. Probengläschen nach Anspruch 1, **dadurch gekennzeichnet, dass** der Hohlraum über die gesamte axiale Länge L des Probengläschens eine in Richtung der x-Achse lang gezogene Form besitzt mit den maximalen Abmessungen a in y-Richtung und b in x-Richtung, wobei a < b.

3. Probengläschen nach Anspruch 1, **dadurch gekennzeichnet, dass** der Hohlraum nur über einen Teilabschnitt ( $L_Z$ ), der kleiner ist als die gesamte axiale Länge L des Probengläschens, eine in Richtung der x-Achse lang gezogene Form besitzt mit den maximalen Abmessungen a in y-Richtung und b in x-Richtung, wobei a < b.

4. Probengläschen nach Anspruch 3, **dadurch gekennzeichnet, dass** der Hohlraum durch ein Probengläschen mit kreisrunder Querschnittsfläche und zwei in dem Probengläschen mit kreisrunder Querschnittsfläche angeordneten Präzisionsschalen der Länge $L_Z$ gebildet wird, wobei die Präzisionsschalen mit der Innenwand des Hohlraums verbunden und möglichst genau diametral zueinander positioniert sind, wobei jede der beiden Präzisionsschalen eine Form besitzt, die entlang der Länge $L_Z$ durch zwei sich über den Umfang schließende Flächen definiert ist, nämlich eine erste, die zylinderförmig ist und möglichst genau die gleiche Krümmung wie die des Hohlraums des Probengläschens besitzt, und eine zweite, die vollständig eben ist und parallel zur Achse der ersten zylinderförmigen Fläche verläuft, wobei die beiden ebenen Flächen der beiden Präzisionsschalen parallel zueinander liegen und einen annähernd rechteckförmigen Hohlraum definieren, der im Betrieb ganz oder teilweise durch eine Probensubstanz gefüllt ist.

5. Probengläschen nach Anspruch 4, **dadurch gekennzeichnet, dass** die Verbindung zwischen den beiden Präzisionsschalen und der kreisrunden Querschnittsfläche des Hohlraums durch einen Verschmelzungsvorgang erzielt wird.

6. Probengläschen nach Anspruch 4 oder 5, **dadurch gekennzeichnet, dass** das untere Ende der beiden Präzisionsschalen mit einer runden Scheibe (6) fest verbunden ist, so dass keine Probensubstanz in den Raum unterhalb der Scheibe gelangen kann.

7. Probengläschen nach einem der vorhergehenden Ansprüche, **dadurch gekennzeichnet, dass** das Ausgangsmaterial zur Herstellung des Probengläschens Glas, oder eine Glasverbindung wie z.B. Pyrex, oder Quarzglas ist.

8. Probengläschen nach einem der vorhergehenden Ansprüche, **dadurch gekennzeichnet, dass** es eine Probensubstanz enthält, die oben und unten durch je einen Suszeptibilitätseinsatz (7a, 7b) abgegrenzt wird, dessen Material einen magnetischen Suszeptibilitätswert besitzt, der annähernd gleich dem der Probensubstanz ist.

9. Probengläschen nach einem der Ansprüche 1-7, **dadurch gekennzeichnet, dass** er zwei Suszeptibilitätseinsätze (7a, 7b) enthält, zwischen denen im betrieb einen Probensubstanz eingeschlossen werden kann, und die Einsätze (7a, 7b) aus einem Material bestehen , das für Probensubstanzen mit wässrigen Lösungsmitteln geeignet ist, beispielsweise "PPS" (p-Phenylen Sulfid) oder "ULTEM" (p-Etherimid).

10. Probengläschen nach Anspruch 8, **dadurch gekennzeichnet, dass** die Suszeptibilitätseinsätze jeweils an einem Ende ein axial verlaufendes Gewinde (8a, 8b) besitzen, in welches eine Montagestange (9) ein- und ausgeschraubt werden kann, wobei diese Montagestange z.B. aus "TEFLON" oder "POM" hergestellt werden kann.

**Claims**

1. Sample tube for an NMR probe head, which extends along a z axis and the interior of which forms a cavity that extends axially in the direction of the z axis, is open to the outside at its axially upper end and is closed at its axially lower end to receive a liquid NMR sample substance, wherein at least over a partial section of the cavity which is smaller than the overall axial length L of the sample tube the cross-sectional surface of this cavity, which extends perpendicularly to the z axis and is parallel to the xy coordinate plane, has an elongated shape in the direction of the x axis and has maximum dimensions a in the y direction and b in the x direction, wherein a<b, **characterized in that** the cross-sectional surface of the sample tube, which extends perpendicularly to the z axis and parallel to the xy coordinate plane has a circular outer shape.

2. Sample tube according to claim 1, **characterized in that** the cavity has an elongated shape in the direction of the x axis along the entire axial length L of the sample tube, having maximum dimensions a in the y direction and b in the x direction, wherein a<b.

3. Sample tube according to claim 1, **characterized in that** the cavity has an elongated shape along the x axis only over a partial section ($L_Z$) which is smaller than the overall axial length L of the sample tube, having maximum dimensions a in the y direction and b in the x direction, wherein a<b.

4. Sample tube according to claim 3, **characterized in that** the cavity has a circular cross-sectional surface and contains two precision shells of a length $L_Z$ which are connected to the inner wall of the cavity and are positioned as exactly diametrally opposite to each other as possible, wherein each of the two precision shells has a shape which is defined along the length $L_Z$ by two surfaces encompassing the periphery, namely a first cylindrical surface which has as exactly as possible the same curvature as the cavity of the sample tube, and a second surface which is completely flat and extends parallel to the axis of the first cylindrical surface, wherein the two flat surfaces of the two precision shells are parallel to each other and define an approximately rectangular cavity which is completely or partially filled with a sample substance during operation.

5. Sample tube according to claim 4, **characterized in that** the connection between the two precision shells and the circular cross-sectional surface of the cavity is obtained by melting.

6. Sample tube according to claim 4 or 5, **characterized in that** the lower end of the two precision shells is solidly connected to a round disk (6) to prevent any sample substance from getting into the space below the disk.

7. Sample tube according to any one of the preceding claims, **characterized in that** the starting material for producing the sample tube is glass or a glass compound, such as e.g. pyrex or quartz glass.

8. Sample tube according to any one of the preceding claims, **characterized in that** it contains a sample substance which is delineated from a susceptibility insert (7a, 7b) on its upper and lower side each whose material has a magnetic susceptibility value which is approximately equal to that of the sample substance.

9. Sample tube according to any one of claims 1-7, **characterized in that** it contains two susceptibility inserts (7a, 7b) between which a sample substance may be enclosed during operation, and the inserts (7a, 7b) consist of a material, which is suited for sample substances with aqueous solvents, e.g. "PPS" (p-phenylene sulfide) or "ULEM" (p-etherimide).

10. Sample tube according to claim 8, **characterized in that** the susceptibility inserts have an axially extending thread (8a, 8b) at one end each, into which an assembly bar (9) can be screwed in or out, wherein this assembly bar may be produced e.g. from "TEFLON" or "POM".

## Revendications

1. Tube à échantillon pour une tête de mesure RMN, qui s'étend suivant un axe z et dont l'espace intérieur forme un espace creux s'étendant axialement dans la direction de l'axe z qui est ouvert vers l'extérieur à l'extrémité axiale supérieure et fermé à l'extrémité axiale inférieure pour recevoir une substance échantillon liquide pour la RMN, la surface de section de cet espace creux qui s'étend perpendiculairement à l'axe z et parallèlement au plan de coordonnées xy possédant, au moins sur une portion de l'espace creux qui est plus petite que la longueur axiale totale L du tube à échantillon, une forme allongée dans la direction de l'axe x et ayant les dimensions maximales a dans la direction y et b dans la direction x, avec a < b,
   **caractérisé en ce que** la surface de section du tube à échantillon qui s'étend perpendiculairement à l'axe z et parallèlement au plan de coordonnées xy possède une forme extérieure circulaire.

2. Tube à échantillon selon la revendication 1, **caractérisé en ce que** l'espace creux possède sur la longueur axiale totale L du tube à échantillon une forme allongée dans la direction de l'axe x ayant les dimensions maximales a dans la direction y et b dans la direction x, avec a < b.

3. Tube à échantillon selon la revendication 1, **caractérisé en ce que** l'espace creux ne possède que sur une portion ($L_z$) qui est plus petite que la longueur axiale totale L du tube à échantillon une forme allongée dans la direction de l'axe x ayant les dimensions maximales a dans la direction y et b dans la direction x, avec a < b.

4. Tube à échantillon selon la revendication 3, **caractérisé en ce que** l'espace creux est formé par un tube à échantillon à surface de section circulaire et deux coupelles de précision de longueur $L_z$ disposées dans le tube à échantillon à surface de section circulaire, les coupelles de précision étant reliées à la paroi intérieure de l'espace creux et positionnées le plus précisément possible diamétralement l'une à l'autre, chacune des deux coupelles de précision possédant une forme qui est définie le long de l'axe $L_z$ par deux surfaces se fermant par la périphérie, à savoir une première qui est cylindrique est possède le plus précisément possible la même courbure que celle de l'espace creux du tube à échantillon, et une deuxième qui est entièrement plane et s'étend parallèlement à l'axe de la première surface cylindrique, les deux surfaces planes des deux coupelles de précision étant parallèles l'une à l'autre et définissant un espace creux approximativement rectangulaire qui, en fonctionnement, est rempli en totalité ou en partie d'une substance échantillon.

5. Tube à échantillon selon la revendication 4, **caractérisé en ce que** la liaison entre les deux coupelles de précision et la surface de section circulaire de l'espace creux est obtenue par un processus de fusion.

6. Tube à échantillon selon la revendication 4 ou 5, **caractérisé en ce que** l'extrémité inférieure des deux coupelles de précision est solidaire d'une plaque ronde (6) afin que la substance échantillon ne puisse pas parvenir dans l'espace situé sous la plaque.

7. Tube à échantillon selon l'une des revendications précédentes, **caractérisé en ce que** le matériau de départ pour fabriquer le tube à échantillon est du verre ou un composé de verre comme par exemple du pyrex ou du verre de quartz.

8. Tube à échantillon selon l'une des revendications précédentes, **caractérisé en ce qu'**il contient une substance échantillon qui est délimitée en haut et en bas par un insert de susceptibilité (7a, 7b) dont le matériau possède une valeur de susceptibilité magnétique qui est approximativement égale à celle de la substance échantillon.

9. Tube à échantillon selon l'une des revendications 1 à 7, **caractérisé en ce qu'**il contient deux inserts de susceptibilité (7a, 7b) entre lesquels, en fonctionnement, une substance échantillon peut être enfermée, et les inserts (7a, 7b) sont réalisés en un matériau qui convient pour des substances échantillons avec des solvants aqueux, par exemple « PPS » (sulfure de polyphénylène) ou « ULTEM » (polyéthérimide).

10. Tube à échantillon selon la revendication 8, **caractérisé en ce que** les inserts de susceptibilité possèdent chacun à une extrémité un filetage (8a, 8b) s'étendant axialement dans lequel une tige de montage (9) peut être vissée et dévissée, cette tige de montage pouvant, par exemple, être fabriquée en « TEFLON » ou en « POM ».

PRIOR ART

**Fig. 1**

PRIOR ART

**Fig. 2**

Fig. 3

Fig. 4

**Fig. 5**

**Fig. 6**

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6917201 B2

- DE 10006324 C1

**In der Beschreibung aufgeführte Nicht-Patentliteratur**

- **TH. DE SWIET.** Optimal electric fields for different sample shapes in high resolution NMR spectroscopy. *JMR,* 2005, vol. 174, 331-334